# EUROPEAN PATENT SPECIFICATION

(11) **EP 1 202 457 B1**
(45) Date of publication and mention of the grant of the patent: **06.08.2003**
(21) Application number: 00123644.7
(22) Date of filing: 30.10.2000
(51) Int. Cl.: H03K 17/30, H02J 7/00, G01R 31/36

(54) **Method and software for switching off battery supplied electronic devices and mobile telephone equipped therewith**
Verfahren und Software zum Abschalten batteriegespeister elektronischer Geräte und damit ausgestattetes Mobiltelefon
Procédé et logiciel de mise hors circuit de dispositifs électroniques alimentés par batterie et téléphone mobile ainsi équipé

(43) Date of publication of application: 02.05.2002
(73) Proprietor: Sony International (Europe) GmbH, 10785 Berlin (DE)
(72) Inventor: OGAWA Naohiro, D- 85609 Ascheim (DE)
(74) Representative: Rupp, Christian, Dipl.Phys.

(56) References cited:
- EP-A- 0 473 187
- US-A- 4 445 090
- US-A- 5 027 294
- US-A- 5 561 361
- US-A- 5 570 025
- US-A- 6 114 831

## Description

The present invention relates to a method for controlling the switch off of a battery supplied electronic device, to a software program for executing such a method when loaded in a computing device of a battery supplied electronic device as well as to a mobile telephone comprising a microprocessor provided with such a software program.

Usually, battery supplied electronic devices such as mobile telephones are provided with a hardware shut down system shutting down the voltage supply of the electronic device as soon as the battery voltage falls under a predefined shut down voltage.

Apart from this hardware system software-based shut down management systems can be provided which do not automatically shut down the function of electronic device but can for example alert the user before the shut down by means of optical and/or acoustical alerts as for example blinking battery symbols on the display of a mobile telephone.

US-A-5,978,422 discloses a circuit for determining and evaluating a data signal with the disturbing direct voltage portion having a signal processor with which the direct voltage portion is determined and then subtracted from the signal. A non-linear control is provided that changes a time constant of the circuit in dependence on the signal curve.

US-A-5,570,025 discloses an annunciator and battery supply measurement system for cellular telephones. This known system furthermore encompasses a method for controlling the switch-off of a battery supply electronic device according to the preamble of claim 1.

It is the object of the present invention to provide for a technique for shutting off the voltage supply of electronic devices with battery supply which can ensure that the voltages only shut off in case the battery voltage actually falls under the pre-set shut off voltage. On the other side in case of "fast" voltage drops the voltage shut off technique should present a quick response.

The object is achieved by means of the features of the independent claims. The dependent claims develop further the central idea of the present invention.

According to a first aspect of the present invention therefore a method for controlling the switch-off of a battery supplied electronic device is proposed. At first a fixed shut down voltage value is set. Then the battery voltage is periodically sampled during operation of the electronic device. The last n sampled battery voltage values are periodically averaged, wherein n is an integer value larger than 1. The average value is compared with the fixed shut down voltage. The battery voltage supply is switched off in case the average value is lower than the fixed shut down value.

The method furthermore comprises the step of calculating the voltage difference (delta voltage) between the last sampled battery voltage and the average value as well as the step of raising the weight of the last sampled battery voltage value for the averaging step in case the voltage difference is larger than a pre-set voltage difference value.

Particularly, the battery voltage supply can be switched off in case the average value is lower than the fixed shut down value consecutively for m times, m being an integer larger than 1.

The weight of the last sampled battery voltage can be raised depending on the number of consecutive voltage difference calculation steps in which the voltage difference is larger than the pre-set voltage difference value.

The weight of the last sampled value can be increased by replacing a number of precedent sampled values of the averaging step by the last sampled value.

The number of replaced precedent sampled values can thereby depend on the value of the voltage difference.

According to a further aspect of the present invention a software program for executing a method as set forth above when loaded in a computing device of a battery supplied electronic device is proposed.

Finally, the invention proposes a mobile telephone comprising a microprocessor provided with such a software program.

Further aspects, objects and advantages of the present invention will become evident for the man skilled in the art when reading the following detailed description of an embodiment of the present invention taken in conjunction with the enclosed figures.

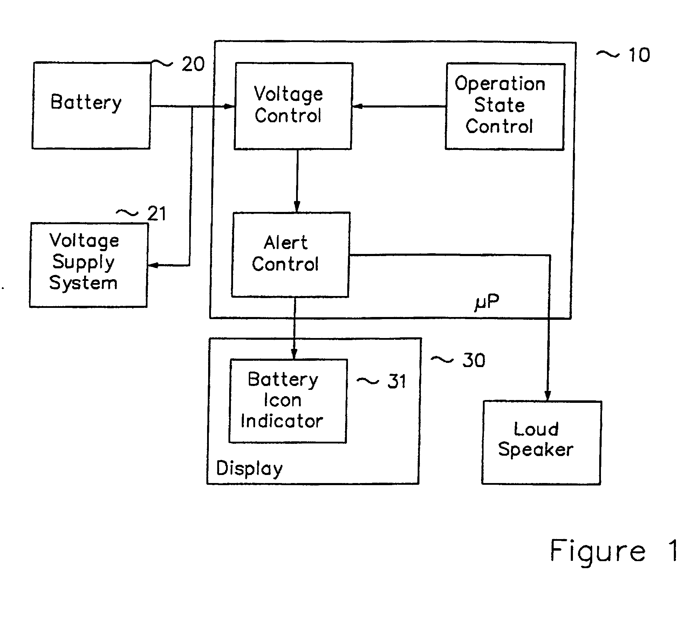

Figure 1 shows a schematic block diagram for a voltage switch off management system, and
Figure 2 shows a flow chart for a voltage switch off management system.

According to the embodiment of the present invention a particular software is implemented in the microprocessor 10 of the electronic device 100 such as a portable mobile telephone, which mobile telephone is supplied by a battery 20. The microprocessor 10 detects (samples) periodically S2, for example in intervals of 1 second, the current battery voltage and shuts off the voltage supply 21, S13 of the electronic device as soon as it can be assured that the current battery voltage has dropped below a pre-set shut off battery voltage. To assure that the battery voltage has not only dropped for a short moment below the pre-set shut off voltage, the invention proposes several procedures. Thereby it is to be noted that the threshold value of the battery voltage depends on the operation state of the mobile telephone, such as for example the idle mode and the talking mode on the one hand and the TX burst periods on the other hand.

The microprocessor can output a signal to a battery icon indicator 31, S11, such that the current battery state can be displayed to the user on the screen 30 of the mobile telephone.

A first pre-set switch off voltage is only valid for the talking mode and the idle mode. This voltage can be defined as for example 3.27 V. For the TX burst transmission burts another threshold voltage can be set.

The microprocessor, as has already been said, samples the battery voltage value and averages for example the last eight sampled values S6. The voltage supply system is only shut down by the microprocessor S13 if the average value of the for example eight sampled values is below the pre-set shut off voltage S9.

According to a preferred embodiment the shut down S13 is only controlled by the microprocessor in case a predefined of for example three consecutive averaging steps resulted in average voltage values below the pre-set shut off voltage S12.

When the mobile telephone changes from the idle mode to the talking mode, the battery voltage usually drops immediately by a predefined value of for example 100 mV. This voltage drop is particularly remarkable if the battery voltage is already near and therefore next to the pre-set shut off voltage. Therefore, the present invention proposes a filtering process S7.

For the purpose of this filtering at first the delta voltage being the difference between the last sampled battery voltage and the average of the for example eight preceding voltage samples is calculated S3. Then the weight of the last sampled battery voltage is increased in the averaging step S6 depending on the value of this calculated voltage difference S5.

For example, when the delta voltage exceeds 30 mV, the microprocessor can copy the last sampled value to the last two sampled values of the eight sampled data.

When the delta voltage exceeds 50 mV, the microprocessor can copy the last sampled value to the last four data of the eight sampled data.

When the delta voltage exceeds 80 mV, the microprocessor can copy the last sampled voltage value to the last six data of the eight sampled data.

Furthermore, when increasing the weight of the last sampled battery voltage value for the averaging step S6, it is taken into account whether the delta voltage calculated as stated above has exceeded a pre-set delta value for more than one time S4.

For example, when the delta voltage exceeds 50 mV for two successively sampled data, the microprocessor can shift the last four data of the eight samples into the first four data of the eight samples and can then copy the last data to the last four data of the eight samples.

The following table explains this filtering process:

| Latest Datum | Late 1^{st} | 2^{nd} | 3^{rd} | 4^{th} | 5^{th} | 6^{th} | 7^{th} | Older 8^{th} | Ave Voltage | Delta Voltage |
|---|---|---|---|---|---|---|---|---|---|---|
| | 3.600 | 3.601 | 3.605 | 3.606 | 3.607 | 3.607 | 3.608 | 3.608 | 3.604 | |
| 3.550 | | | | | | | | | | 0.054 |
| | 3.550 | 3.550 | 3.550 | 3.550 | 3.607 | 3.607 | 3.608 | 3.608 | 3.579 | |
| 3.527 | | | | | | | | | | 0.052 |
| | 3.527 | 3.527 | 3.527 | 3.527 | 3.550 | 3.550 | 3.550 | 3.550 | 3.539 | |
| 3.500 | | | | | | | | | | 0.039 |
| | 3.500 | 3.500 | 3.527 | 3.527 | 3.550 | 3.550 | 3.550 | 3.550 | 3.532 | |

During the TX burst period the microprocessor effects an emergency system shut down. In this case, before shutting down the system the microprocessor performs the following steps:

The microprocessor alerts the user S11 just before the shut down for example by acoustical (beeps) or optical (blinking battery symbol on the display) alerts.

When a microprocessor detects a battery voltage lower than the emergency system shut down voltage (which is below the shut off voltage of the idle and talking mode) for consecutive three times S12, the system is shut down S13.

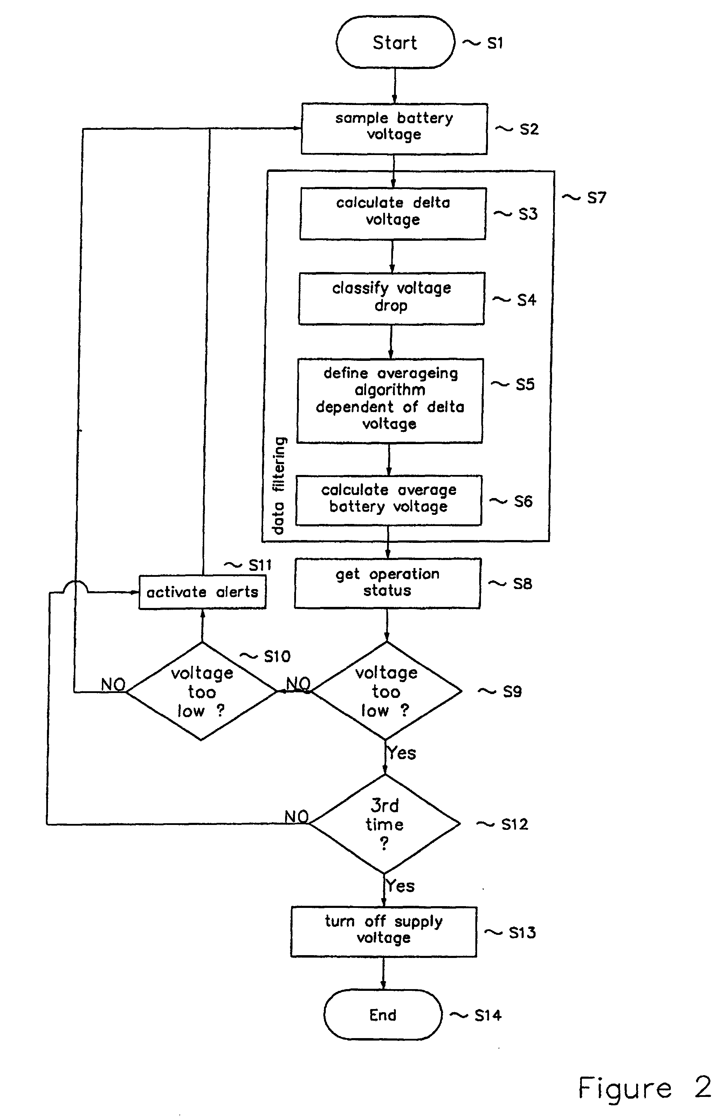

Figure 2 shows a flow chart representation of the processing steps of a special embodiment of the present invention. The battery voltage is sampled periodically S2 and the obtained value is compared both with the average value from the preceding voltage measurements S3 and the difference between the two values as calculated from the delta voltage. If the absolute value of the delta voltage exceeds a certain value, the resulting voltage drop is detected by noting the amount of the voltage drop and the number of times it has already occurred S4. Depending on the amount of the voltage drop as well as its frequency a suited averaging algorithm like described above will be selected S7. Next, the new average battery voltage value will be calculated according to the averaging algorithm selected before S6. Before a decision can be made whether the calculated average battery value is lower than one of the pre-set voltage thresholds, the operation status of the electronic device is examined S8 and according to this the appropriate voltage threshold value is chosen for deciding S9 if the calculated average battery voltage value is below the threshold value or not.

Assumed the average battery voltage has been lower than the threshold value, it is checked if this event occurred already for a third time or not S12. If there is an affirmative result, the supply voltage will be turned off S13. In case the average battery voltage was too low for the first or for the second time, alerts will be activated S11 like for example a blinking of the battery symbol 31 and the display 30 of the electronic device and then the battery voltage will be sampled again S2. Assumed that back at step S9 the average battery voltage has not been below the pre-set threshold value, it will be checked if the battery voltage is near the threshold value S10, and if yes, the alerts will be activated S11. If the battery voltage is sufficiently above the pre-set threshold value, the system will return to sampling the battery voltage S2.

## Claims

1. Method for controlling the switch-off of a battery supplied electronic device, the method comprising the following steps:
- setting a fixed shut down voltage value,
- periodically sampling the battery voltage (S2),
- periodically averaging the last n sampled battery voltage values (S6), wherein n is an integer larger than one,
- comparing the average value with the fixed shut down voltage (S9), and
- switching off the battery voltage supply (S13) in case the average value is lower than the fixed shut down value, **characterized by** the steps of
- calculating (6) the voltage difference between the last sampled battery voltage and the average value (S3), and
- raising the weight of the last sampled battery voltage value for the averaging step in case the voltage difference is larger than a pre-set voltage difference value (S5, S6).

2. Method according to claim 1,
**characterised in that**
the battery voltage supply is switched off in case the average value is lower than the fixed shut down value consecutively for m times (S12), m being an integer larger than one.

3. Method according to claim 1,
**characterised in that**
the weight of the last sampled battery voltage is raised depending on the number of consecutive voltage difference calculation steps (S3) in which the voltage difference has been larger than the pre-set voltage difference value (S4).

4. Method according to claim 1 or 3,
**characterised in that**
the weight of the last sampled value is increased by replacing a number of precedent sample values of the averaging step by the last sample value.

5. Method according to claim 4,
**characterised in that**
the number of replaced precedent sample values depends on the value of the voltage difference.

6. Method according to anyone of the preceding claims,
**characterised in that**
the shut-down voltage value depends on the operation state of the electronic device (S8).

7. Software program for executing a method according to anyone of the preceding claims when loaded in a computing device of a battery supplied electronic device.

8. Mobile telephone comprising a microprocessor provided with a software program according to claim 7.

## Patentansprüche

1. Verfahren zum Steuern des Abschaltens einer von einer batterie-gespeisten elektronischen Einrichtung, wobei das Verfahren die folgenden Schritte aufweist:
- Festsetzen eines festen Abschaltspannungswerts,
- periodisches Abtasten der Batteriespannung (S2),
- periodische Mittelwertbildung der zuletzt n abgetasteten Batteriespannungswerte (S6), wobei n eine ganze Zahl größer als 1 ist,
- Vergleichen des Mittelwerts mit der festen Abschaltspannung (S9), und
- Abschalten der Batteriespannungsversorgung (S13) in dem Fall, wenn der Mittelwert niedriger ist als der feste Abschaltwert, **gekennzeichnet durch** folgende Schritte:
- Berechnen (6) der Spannungsdifferenz zwischen der zuletzt abgetasteten Batteriespannung und dem Mittelwert (S3), und
- Anheben der Bewertung des zuletzt abgetasteten Batteriespannungswerts für einen Mittelwertbildungsschritt in dem Fall, wo die Spannungsdifferenz größer ist als ein vorher festgelegter Spannungsdifferenzwert (S5, S6).

2. Verfahren nach Anspruch 1, **dadurch gekennzeichnet, daß** die Batteriespannungsversorgung in dem Fall abgeschaltet wird, wenn der Mittelwert m Mal (S12) hintereinander niedriger ist als der feste Abschaltwert, wobei m eine ganze Zahl größer als 1 ist.

3. Verfahren nach Anspruch 1, **dadurch gekennzeichnet, daß** die Bewertung der zuletzt abgetasteten Batteriespannung in Abhängigkeit von der Anzahl von aufeinanderfolgenden Spannungsdifferenz-Berechnungsschritten (S3) angehoben wird, in denen die Spannungsdifferenz größer war als der vorher festgelegte Spannungsdifferenzwert (S4).

4. Verfahren nach Anspruch 1 oder 3, **dadurch gekennzeichnet, daß** die Bewertung des zuletzt abgetasteten Werts durch Ersetzen einer Anzahl von vorhergehenden Abtastwerten des Mittelwertbildungsschritts durch den letzten Abtastwert angehoben wird.

5. Verfahren nach Anspruch 4, **dadurch gekennzeichnet, daß** die Anzahl von ersetzten vorhergehenden Abtastwerten vom Wert der Spannungsdifferenz abhängt.

6. Verfahren nach einem der vorhergehenden Ansprüche, **dadurch gekennzeichnet, daß** der Abschaltspannungswert vom Betriebszustand der elektronischen Einrichtung (S8) abhängt.

7. Software-Programm zum Ausführen eines Verfahrens gemäß einem der vorhergehenden Ansprüche, wenn dieses in eine Computereinrichtung einer batterie-gespeisten elektronischen Einrichtung geladen wird.

8. Mobiltelefon mit einem Mikroprozessor, der mit einem Software-Programm gemäß Anspruch 7 beliefert wird.

## Revendications

1. Procédé pour contrôler la coupure d'un dispositif électronique alimenté par batterie, le procédé comprenant les étapes de :
- réglage d'une valeur de tension de coupure fixe,
- échantillonnage périodiquement de la tension de batterie (S2),
- calcul périodiquement de la moyenne des n dernières valeurs de tension de batterie échantillonnées (S6), où n est un entier supérieur à 1,
- comparaison de la valeur moyenne avec la tension de coupure fixe (S9), et
- coupure de la tension d'alimentation de batterie (S13) dans le cas où la valeur moyenne est inférieure à la valeur de coupure fixe, **caractérisé par** les étapes de :
- calcul (6) de la différence de tension entre la dernière tension de batterie échantillonnée et la valeur moyenne (S3), et
- augmentation de la pondération de la dernière valeur de tension de batterie échantillonnée pour l'étape de calcul de moyenne dans le cas où la différence de tension est supérieure à une valeur de différence de tension préréglée (S5, S6).

2. Procédé selon la revendication 1, **caractérisé en ce que** l'alimentation de tension de batterie est coupée dans le cas où la valeur moyenne est inférieure à la valeur de coupure fixe consécutivement de m fois (S12), m étant un entier supérieur à un.

3. Procédé selon la revendication 1, **caractérisé en ce que** la pondération de la dernière tension de batterie échantillonnée est augmentée en fonction du nombre d'étapes de calcul de différence de tension consécutif (S3) dans lequel la différence de tension a été plus grande que la valeur de différence de tension préréglée (S4).

4. Procédé selon la revendication 1 ou 3, **caractérisé en ce que** la pondération de la dernière valeur échantillonnée est augmentée en remplaçant le nombre de valeurs d'échantillons précédentes de l'étape de moyenne par la dernière valeur d'échantillon.

5. Procédé selon la revendication 4, **caractérisé en ce que** le nombre de valeurs d'échantillons précédentes remplacées dépend de la valeur de la différence de tension.

6. Procédé selon l'une quelconque des revendications précédentes, **caractérisé en ce que**
la valeur de tension de coupure dépend de l'état de fonctionnement du dispositif électronique (S8).

7. Programme logiciel pour exécuter un procédé selon l'une quelconque des revendications précédentes lorsqu'il est chargé dans un dispositif de calcul du dispositif électronique alimenté par batterie.

8. Téléphone mobile comprenant un microprocesseur pourvu d'un programme logiciel selon la revendication 7.
